# EUROPÄISCHE PATENTSCHRIFT

(11) **EP 0 965 871 B1**
(45) Veröffentlichungstag und Bekanntmachung des Hinweises auf die Patenterteilung: **05.10.2005**
(21) Anmeldenummer: 99110255.9
(22) Anmeldetag: 27.05.1999
(51) Int. Cl.: G02B 7/02, G03F 7/20

(54) **Verfahren zur Korrektur nichtrotationssymmetrischer Bildfehler**
Method for correcting rotationally asymmetric imaging aberrations
Procédé pour la correction des défauts optiques asymètriques en rotation

(30) Priorität: 20.06.1998 DE 19827602
(43) Veröffentlichungstag der Anmeldung: 22.12.1999
(73) Patentinhaber: Carl Zeiss SMT AG, 73446 Oberkochen (DE)
(72) Erfinder: Rupp, Wolfgang Dr., 73434 Aalen (DE)
(74) Vertreter: Müller-Rissmann, Werner Albrecht

(56) Entgegenhaltungen:
- EP-A- 0 532 236
- EP-A- 0 678 768
- WO-A-97/45902
- US-A- 5 099 355
- US-A- 5 353 292
- US-A- 5 671 307
- US-A- 5 883 704
- PATENT ABSTRACTS OF JAPAN vol. 199, no. 508, 29. September 1995 (1995-09-29) -& JP 07 120650 A (NIKON CORP), 12. Mai 1995 (1995-05-12)

## Beschreibung

Die Erfindung betrifft ein Verfahren nach dem Oberbegriff von Anspruch 1. Die Erfindung betrifft weiterhin auch ein Objektiv mit optischen Elementen, insbesondere Linsen, nach dem Oberbegriff von Anspruch 6. Des weiteren bezieht sich die Erfindung auf eine Projektionsbelichtungsanlage der Mikrolithographie.

Es ist bekannt, daß "Lens-Heating"-Effekte unter anderem zu nicht-rotationssymmetrischen Temperaturverteilungen in optischen Elementen, insbesondere in Linsen von Halbleiterlithographie-Objektiven führen. Nicht-rotationssymmetrische Temperaturverteilungen ergeben jedoch optische Bildfehler, wie Astigmatismus in der Achse und Anamorphismus in der Verzeichnung (Δβ).

Durch geeignete geometrische Anordnungen von wärmeabführenden Kontaktstellen, insbesondere am Linsenumfang, könnte man einen statischen Zustand einer nicht-rotationssymmetrischen Temperaturverteilung korrigieren. Es wurde jedoch festgestellt, daß die Lens-Heating-Effekte ein sehr ausgeprägtes dynamisches Verhalten aufweisen. Insbesondere die Amplituden der Effekte sind sehr stark zeitabhängig, während die Zeitkonstanten relativ lang sind und zwar in der Größenordnung von mehreren Minuten liegen. Aus diesem Grunde ist es zur Beseitigung der vorstehend genannten optischen Bildfehler erforderlich eine dynamische bzw. variabel einstellbare Temperaturverteilung zu schaffen, die rasch und zuverlässig den nicht-rotationssymmetrischen Temperaturverteilungen in dem optischen Element entgegenwirken kann.

Aus der EP 0 678 768 sind bereits Maßnahmen zur Korrektur rotations-asymmetrischer optischer Effekte, die durch Bestrahlung verursacht werden, bekannt. Hierzu werden unter anderem Maßnahmen zur Erzeugung rotationssymmetrischer Temperaturverteilungen genannt, wozu Kühl- und Heizeinrichtungen, z.B. Widerstandsdrähte und Gasströme, vorgeschlagen werden. Die Erzeugung rotationssymmetrischer Temperaturverteilungen ist jedoch nicht unbedingte Voraussetzung um Lens-Heating-Effekte kompensieren zu können. Die vorbekannte Einrichtung ist jedoch zum einen relativ umständlich und aufwendig und zum anderen lässt sie keine ausreichende Dynamik bezüglich Änderungen einer Temperaturverteilung zu.

Ein Verfahren zur Korrektur von Bildfehlern von Linsen mittels am Umfang der Linse angeordneten Peltier-Elementen ist aus der JP 07 120650A bekannt, wobei zwischen den Peltier-Elementen und der Linse eine wärmeleitende Verbindung hergestellt ist. Dabei kann bei schlechterwerdender Bildqualität mittels der Peltier-Elemente die Brennweite der Linse so verändert werden, dass sich die Bildqualität verbessert.

Die US 5,883,704 Patentschrift beschreibt ein optisches Projektionssystem bei dem an wenigstens einem Linsenelement zu dessen Temperaturkontrolle Peltier-Elemente angeordnet sind. Dabei werden die Peltier-Elemente über eine Temperaturkontrollvorrichtung angesteuert, um eine bestimmte Temperatur dieses Linsenelements einzustellen, um z. B. den nichtlinearen Vergrößerungsfehler zu korrigieren.

Die erste Aufgabe der vorliegenden Erfindung ist die Verbesserung der dynamischen Eigenschaften bei der Korrektur von Bildfehlern.

Der vorliegenden Erfindung liegt ferner die weitere Aufgabe zugrunde, ein Verfahren zur Korrektur nicht-rotationssymmetrischer Bildfehler bei einer Baugruppe, z.B. einem Objektiv mit optischen Elementen zu schaffen, wobei mit einfachen Maßnahmen dynamisch bzw. variabel einstellbare Temperaturverteilungen zur Kompensation der negativen Lens-Heating-Effekte in einem optischen Element erzeugt werden können, wobei diese Temperaturverteilungen mit einfachen Maßnahmen rasch und zuverlässig erreicht werden sollen.

Erfindungsgemäß wird die erste Aufgabe durch die im kennzeichnenden Teil von Anspruch 1 genannten Verfahrensschritte gelöst.

In überraschender Weise hat sich nämlich herausgestellt, daß Peltier-Elemente für die Lösung der gestellten Aufgabe besonders geeignet sind, wenn sie entsprechend den erfindungsgemäßen Maßnahmen eingesetzt werden.

Bekanntlich führt bei Peltier-Elementen ein Stromfluß durch eine Kontaktstelle zwischen zwei unterschiedlichen Materialien in einer Richtung zu einer Abkühlung der Kontaktstelle, eine Umpolung des Stromflusses führt dagegen zu einer Erwärmung der Kontaktstelle.

Zwar ist es bereits bekannt diesen Effekt von Peltier-Elementen zur Kühlung von Einrichtungen einzusetzen (siehe z.B. WO 97/14077 für Wafer-chucks), da aber die beim "Lens-Heating" aus einem optischen Element, insbesondere einer Linse, einer Projektionsbelichtungsanlage der Mikrolithographie abzuführende Wärmemenge sehr hoch ist, nämlich im Wattbereich, war man der Annahme, daß Peltier-Elemente für die Beseitigung derartiger Lens-Heating-Effekte nicht ausreichend geeignet wären. Es hat sich jedoch herausgestellt, daß bei einer entsprechenden Anzahl von Peltier-Elementen in Verbindung mit einer spezifischen Ansteuerung eine derart dynamisch einstellbare Temperaturverteilung in dem optischen Element rasch und zuverlässig eingestellt werden kann, daß die nachteiligen Wirkungen der Lens-Heating-Effekte beseitigt werden können. Auch die relativ hohe anfallende Wärmemenge kann innerhalb kurzer Zeit abgeführt werden. Es wurde nämlich festgestellt, daß durch die spezifische Steuerbarkeit von Peltier-Elementen und deren Zwei-Richtungs-Eignung, d.h. deren Umstellung zwischen Kühlen und Heizen, auf das zum Teil rasche dynamische Verhalten der Lens-Heating-Effekte optimal eingegangen werden kann. Peltier-Elemente lassen sich durch Umpolen der elektrischen Versorgung zwischen Kühlen und Heizen umschalten. Dies bedeutet, ohne ein Zwischenschalten von mechanisch beweglichen Komponenten kann sehr schnell und exakt auf Temperaturunterschiede und sich ändernde Temperaturverteilungen reagiert werden.

Bei dem erfindungsgemäßen Verfahren lassen sich die gewünschten Temperaturverteilungen mit einfachen Maßnahmen rasch und zuverlässig erreichen. Dies ist insbesondere dann der Fall, wenn nur bestimmte Bildfehler, z.B. Bildfehler niederer Ordnung, korrigiert werden sollen.

Ein weiterer sehr bedeutender Vorteil der Erfindung besteht darin, daß im Bedarfsfalle auch "Überkompensierungen" und die zusätzliche Kompensation von Fertigungsfehlern möglich ist. Anstelle von einer Symmetriesierung von mehreren einzelnen Linsen, wie es beim Stand der Technik der Fall ist, kann man auch einzelne Linsen "überkompensieren", d.h. die Temperaturverteilung bzw. Deformation bewußt "in eine andere Richtung" unsymmetrisch zu machen. Auf diese Weise ergibt sich dann insgesamt gesehen eine Kompensierung des ganzen Objektives oder der Belichtungsanlage.

Bezüglich einer Kompensation von Fertigungsfehlern gibt es zwei Varianten, nämlich eine gleichzeitige Kompensation zufälliger Fertigungsfehler und ein absichtlicher Einbau eines festen Vorhalts, um die benötigten Korrekturbeträge zu halbieren.

Mit dem erfindungsgemäßen Verfahren ist auch eine gleichzeitige Kompensation von Lens Heating und von Compaction Effekten des optischen Elementes möglich.

Eine konstruktive Lösung zur Durchführung des erfindungsgemäßen Verfahrens bei einer Baugruppe, z.B. einem Objektiv mit optischen Elementen, insbesondere Linsen, ist in Anspruch 6 genannt.

Die Peltier-Elemente können dabei regelmäßig oder auch unregelmäßig über den Umfang des optischen Elementes angeordnet sein. Wesentlich ist, daß sie beliebig bzw. unterschiedlich elektrisch angesteuert werden, um die Temperaturverteilung in dem optischen Element in gewünschter Weise beeinflussen zu können. Dabei ist lediglich dafür zu sorgen, daß sehr gut wärmeleitende Verbindungsglieder zwischen den Peltier-Elementen und dem optischen Element vorgesehen sind, damit eine gute Wärme- bzw. Kälteleitung zwischen den Peltier-Elementen und dem optischen Element erreicht wird.

Für die Ausgestaltung der wärmeleitenden Verbindungsglieder sind verschiedene Lösungen denkbar. In einfacher Weise kann man hierzu die Fassung oder Halterung des optischen Elementes verwenden. Ebenso ist es jedoch auch möglich, die Peltier-Element separat von einer Fassung oder Halterung anzuordnen und entsprechende wärmeleitende Verbindungsglieder zwischen den Peltier-Elementen und dem optischen Element vorzusehen.

Zur Ableitung der abgeführten Wärme wird man die Peltier-Element zusätzlich mit entsprechenden Wärmekopplungsgliedern versehen, die die Wärme nach außen abführen.

Vorteilhafte Ausgestaltungen der Erfindung ergeben sich aus den nachfolgend anhand der Zeichnung prinzipmäßig beschriebenen Ausführungsbeispielen.

Es zeigt:
- Figur 1: eine Linse als optisches Element eines Objektives, wobei Peltier-Elemente auf einer Fassung der Linse angeordnet sind (ohne Wärmekopplungsglieder);
- Figur 2: einen Schnitt nach der Linie II-II der Figur 1;
- Figur 3: eine Linse als optisches Element eines Objektives, wobei Peltier-Elemente direkt an die Linse angekoppelt sind;
- Figur 4: einen Schnitt nach der Linie IV-IV der Figur 3.

Eine Linse 1 als optisches Element ist über eine Fassung bzw. Halterung 2 in einem nicht näher dargestellten Objektiv 3, von dem nur ein Wandabschnitt dargestellt ist, in bekannter Weise angeordnet. Die Fassung 2 ist mit mehreren über deren Umfang verteilten und nach innen gerichteten Linsenauflagen 4 versehen, durch die in Verbindung mit einem Kleber 5 die Linse 1 gehalten ist.

An bzw. auf der Fassung 2 sind über dem Umfang der Fassung 2 verteilt eine Vielzahl von Peltier-Elementen 6 angeordnet, welche jeweils mit Stromanschlüssen 7 und 8 für + und - versehen sind. Auf der von der Fassung 2 abgewandten Seite der Peltier-Elemente 6 ist jeweils ein Wärmekopplungsglied 9 vorgesehen, durch das eine Wärmeabfuhr zur Außenseite erfolgt. Entsprechend der Höhe der jeweiligen Eingangsströme bzw. Spannung zu den Peltier-Elementen 6 ergibt sich auf der zu der Fassung 2 gerichteten Seite der Peltier-Elemente 6 ein Kühleffekt, der über die Linsenauflagen 4 in die Linse 1 eingeleitet wird. Da die Peltier-Elemente 6 jeweils einzeln oder auch in Gruppen mit unterschiedlichen Stromstärken bzw. Spannungen ansteuerbar sind, kann in optimaler Weise auf die Temperaturverteilung in der Linse 1 derart eingewirkt werden, daß die durch die Lens-Heating-Effekte erzeugten nicht-rotationssymmetrischen Temperaturverteilungen kompensiert werden können. Durch eine zusätzliche Umschaltmöglichkeit der Polung von einzelnen oder mehreren Peltier-Elementen 6 kann noch schneller auf sich ändernde Temperaturverteilungen in der Linse 1 reagiert werden. Bei einer entsprechenden Umschaltung kann nämlich durch einzelne Peltier-Elemente 6 auch eine Heizwirkung über die Fassung 2 auf die da-zugehörige Linsenauflage 4 in Richtung auf die Linse 1 erzeugt werden.

Aufgrund dieser hohen Variabilität der Peltier-Elemente 6 (Kühlen/Heizen über Polung der Spannung und der Stromstärke einstellbar) können beliebige Temperaturprofile, d.h. nicht nur rotationssymmetrische Profile, eingestellt werden, so daß die optische Wirkung des optischen Elementes, in diesem Falle der Linse 1, gemäß der aktuell eingestellten Temperaturverteilung variabel eingestellt werden kann; z.B. astigmatische Wirkung mit beliebiger Amplitude und Richtung, aber auch Kompensation oder Überkompensation eines - dynamischen - Astigmatismus.

Darüber hinaus können im Bedarfsfalle auch asymmetrische Profile - evtl. zum Vorhalt gegenüber anderer Linsenelemente im Objektiv, zur Kompensation von Off-Axis-Feldern oder zur Kompensation von Fertigungs-Homogenitätsfehlern - eingestellt werden.

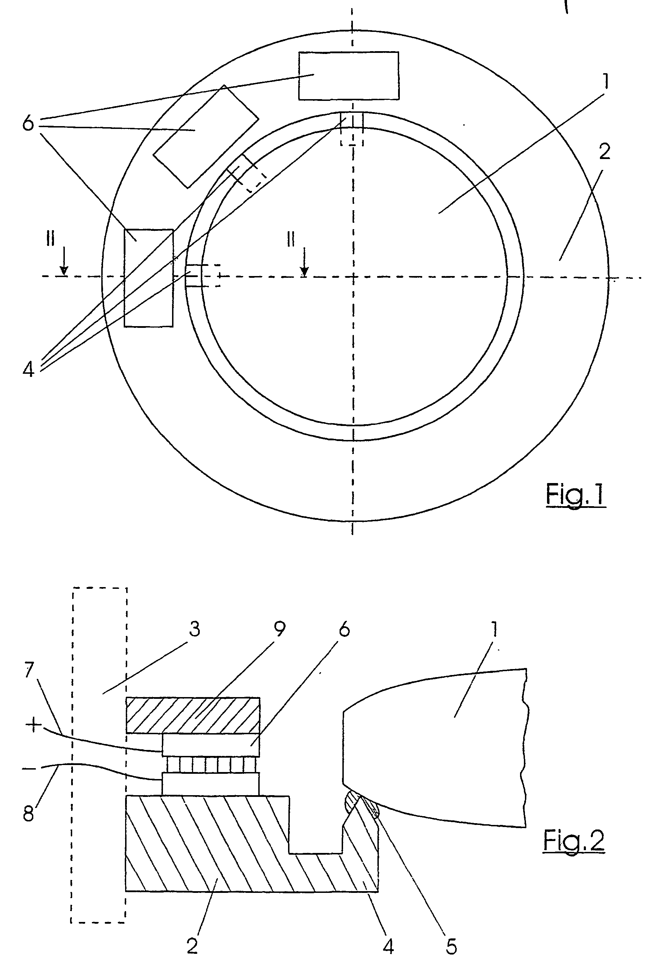

Bei dem Ausführungsbeispiel nach den Figuren 1 und 2, wobei die Fassung 2 die zusätzliche Funktion eines wärmeleitenden Verbindungsgliedes übernimmt, wird durch die Peltier-Elemente 6 zwar keine eventuell störende Kraft auf die Linse erzeugt, allerdings kann auf Temperaturdifferenzen nur langsamer und weniger sensitiv reagiert werden.

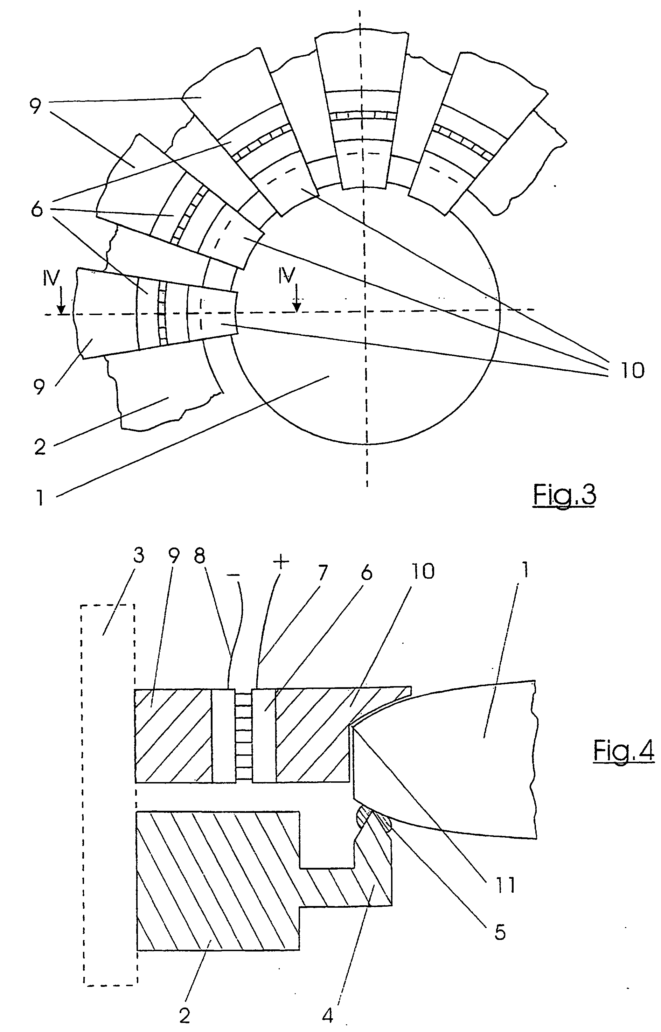

In der Ausführungsform nach den Figuren 3 und 4 ist eine Ausgestaltung dargestellt, wobei die Peltier-Elemente 6 direkt an die Linse 1 angekoppelt sind, womit sehr schnell und sensitiv auch auf kleine Temperaturdifferenzen reagiert werden kann.

Wie ersichtlich, sind dabei die Peltier-Elemente 6 unabhängig von der Fassung 2 und den Linsenauflagen 4 angeordnet. Aus diesem Grunde sind separate wärmeleitende Verbindungsglieder 10 zwischen den über den Umfang der Linse 1 verteilt angeordneten Peltier-Elementen 6 und der Linse 1 vorzusehen, die einen entsprechend guten Kontakt zwischen diesen beiden Teilen herstellen. Auf den von den wärmeleitenden Verbindungsgliedern 10 abgewandten Seiten der Peltier-Elemente 6 ist jeweils ein Wärmekopplungsglied 9 vorgesehen, das dem Wärmekopplungsglied 9 nach dem Ausführungsbeispiel nach den Figuren 1 und 2 entspricht und über das die Wärme nach außen abgeleitet wird.

Wie aus der Fig. 4 ersichtlich ist, können die Verbindungsglieder 10 auf ihren von den Linsenauflagen 4 abgewandten Seiten mit zur Linse 1 gerichteten Nasen 11 versehen sein, womit zum einen die Wärme- bzw. Kälteübergangsfläche vergrößert wird und zum anderen eine zusätzliche Einfassung für die Linse 1 geschaffen wird.

## Patentansprüche

1. Verfahren zur Korrektur nicht-rotationssymmetrischer Bildfehler bei einer Baugruppe mit optischen Elementen (1), insbesondere Linsen (1), wobei an mindestens einem optischen Element (1) über den Umfang verteilt mehrere Peltier-Elemente (6) angeordnet sind, die zur Beeinflussung der Temperaturverteilung in dem optischen Element (1) unterschiedlich elektrisch angesteuert werden, wobei zwischen den Peltier-Elementen (6) und dem optischen Element (1) wärmeleitende Verbindungen hergestellt werden, und durch das unterschiedliche elektrische Ansteuern der Peltier-Elemente (6) diese das optische Element (1) kühlen und heizen, **dadurch gekennzeichnet, dass** die Peltier-Elemente (6) direkt an das als Linse (1) ausgebildete optische Element (1) ankoppeln, wobei die Peltier-Elemente (6) separat von der Fassung (2) und der Linsenauflage (4) der Linse (1) direkt über separate wärmeleitende Verbindungsglieder (10) an die Linse (1) augekoppelt sind.

2. Verfahren nach Anspruch 1 **dadurch gekennzeichnet, dass** die Peltier-Elemente (6) auf ein als Linse (1) mit zugehöriger Linsenauflage (4) ausgebildetes optisches Element (1) einen Kühleffekt und eine Heizwirkung über die Linsenauflage (4) in Richtung auf die Linse (1) erzeugen.

3. Verfahren nach einem der Ansprüche 1 und 2, **dadurch gekennzeichnet, dass** die Bildfehler sich aus Compaction-Effekte ergeben.

4. Verfahren nach einem der Ansprüche 1 bis 3, **dadurch gekennzeichnet, dass** die Bildfehler Astigmatismus und/oder dynamischen Astigmatismus umfassen.

5. Verfahren nach einem der Ansprüche 1 bis 4, **dadurch gekennzeichnet, dass** das Kühlen und Heizen zur Einstellung asymmetrischer Temperaturprofile des optischen Elements (1), an welchem die Peltier-Elemente (6) angeordnet sind, dienst, um einen Vorhalt gegenüber anderen Linsenelementen, eine Kompensation von Off-Axis-Feldern oder eine Kompensation von Fertigungsfehlern zu erzielen.

6. Baugruppe mit optischen Elementen, insbesondere Linsen, mit einer Temperiereinrichtung, wobei an mindestens einem der optischen Elemente (1) über dessen Umfang verteilt mehrere Peltier-Elemente (6) angeordnet sind, und wobei zwischen den Peltier-Elementen (6) und dem optischen Element (1) wärmeleitende Verbindungsglieder (10) angeordnet sind, mit einer Umschaltmöglichkeit der Polung von einzelnen oder mehreren Peltier-Elementen (1) die einzeln ansteuerbar sind, **gekennzeichnet dadurch, dass** die Peltier-Elemente (6) separat von der Fassung (2) des optischen Elements (1) direkt über separate wärmeleitende Verbindungsglieder (10) an das als Linse (1) ausgebildete optische Element (1) angekoppelt sind.

7. Baugruppe nach Anspruch 6, **dadurch gekennzeichnet, dass** die Peltier-Elemente (1) mit nach außen gerichteten Wärmekopplungsgliedern (9) versehen sind.

8. Baugruppe nach Anspruch 6 oder 7, **dadurch gekennzeichnet, dass** die Peltier-Elemente (6) über die wärmeleitende Verbindungsglieder (10), die jeweils zwischen einem Peltier-Element (6) und dem optischen Element (1) angeordnet sind, direkt an das optische Element (1) angekoppelt sind.

9. Baugruppe nach Anspruch 8, **dadurch gekennzeichnet, dass** die wärmeleitenden Verbindungsglieder (10) mit zu dem optischen Element (1) gerichteten Nasen versehen sind.

10. Baugruppe nach einem der Ansprüche 6 bis 9, **dadurch gekennzeichnet, dass** sie ein Objektiv (3), insbesondere ein Projektionsobjektiv der Mikrolithographie, ist.

11. Projektionsbelichtungsanlage der Mikrolithographie mit einer Baugruppe nach einem der Ansprüche 6 bis 10.

## Claims

1. Method for correcting rotationally asymmetric aberrations in the case of an assembly with optical elements (1), in particular lenses (1), there being arranged on at least one optical element (1) in a fashion distributed over the circumference a number of Peltier elements (6) which are driven electrically in different fashion in order to influence the temperature distribution in the optical element (1), thermally conducting connections being produced between the Peltier elements (6) and the optical element (1), and the Peltier elements (6) cooling and heating the optical element (1) owing to their being driven electrically in different fashion, **characterized in that** the Peltier elements (6) are coupled directly onto the optical element (1) designed as a lens (1), the Peltier elements (6) being coupled, separately from the mount (2) and the lens support (4) of the lens (1), directly onto the lens (1) via separate thermally conducting connecting members (10).

2. Method according to Claim 1, **characterized in that** the Peltier elements (6) exert a cooling effect on an optical element (1) designed as a lens (1) with associated lens support (4), and exert a heating action in the direction of the lens (1) via the lens support (4).

3. Method according to either of Claims 1 or 2, **characterized in that** the aberrations result from compaction effects.

4. Method according to one of Claims 1 to 3, **characterized in that** the aberrations comprise astigmatism and/or dynamic astigmatism.

5. Method according to one of Claims 1 to 4, **characterized in that** the cooling and heating serves the purpose of setting asymmetric temperature profiles of the optical element (1) on which the Peltier elements (6) are arranged, in order to achieve an offset on other lens elements, a compensation of off-axis fields or a compensation of manufacturing defects.

6. Assembly with optical elements, in particular lenses, having a temperature-regulating device, a number of Peltier elements (6) being arranged on at least one of the optical elements (1) in a fashion distributed over the circumference thereof, and thermally conducting connecting members (10) being arranged between the Peltier elements (6) and the optical element (1) and exhibiting the possibility of switching over the polarity of individual, or a number of, Peltier elements (6) which can be driven individually, **characterized in that** the Peltier elements (6) are coupled, separately from the mount (2) of the optical element (1), directly onto the optical element (1) designed as a lens (1) via separate thermally conducting connecting members (10).

7. Assembly according to Claim 6, **characterized in that** the Peltier elements (6) are provided with outwardly directed thermal coupling elements (9).

8. Assembly according to Claim 6 or 7, **characterized in that** the Peltier elements (6) are directly coupled onto the optical element (1) via the thermally conducting connecting members (10) which are respectively arranged between a Peltier element (6) and the optical element (1).

9. Assembly according to Claim 8, **characterized in that** the thermally conducting connecting members (10) are provided with noses directed towards the optical element (1).

10. Assembly according to one of Claims 6 to 9, **characterized in that** it is an objective (3), in particular a projection objective used in microlithography.

11. Projection exposure machine used in microlithography and having an assembly according to one of Claims 6 to 10.

## Revendications

1. Procédé de correction des défauts optiques sans symétrie rotationnelle sur un sous-ensemble comprenant des éléments optiques (1), notamment des lentilles (1), plusieurs éléments de Peltier (6) étant disposés sur au moins un élément optique (1) en étant répartis sur le pourtour, lesquels sont commandés électriquement différemment pour influencer la répartition de la température dans l'élément optique (1), des liaisons conductrices de chaleur étant établies entre les éléments de Peltier (6) et l'élément optique (1) et les éléments de Peltier (6) refroidissant et chauffant l'élément optique (1) du fait des modes de commande électrique différents, **caractérisé en ce que** les éléments de Peltier (6) se couplent directement à l'élément optique (1) réalisé sous la forme d'une lentille (1), les éléments de Peltier (6) étant couplés à la lentille (1) séparément de la monture (2) et de l'appui de lentille (4) de la lentille (1) directement par le biais d'éléments de liaison (10) séparés conducteurs de chaleur.

2. Procédé selon la revendication 1, **caractérisé en ce que** les éléments de Peltier (6) produisent, sur un élément optique (1) réalisé sous la forme d'une lentille (1) avec un appui de lentille (4) correspondant, un effet de refroidissement et un effet de chauffage sur l'appui de lentille (4) en direction de la lentille (1).

3. Procédé selon l'une des revendications 1 et 2, **caractérisé en ce que** les défauts optiques résultent d'effets de compactage.

4. Procédé selon l'une des revendications 1 à 3, **caractérisé en ce que** les défauts optiques comprennent de l'astigmatisme et/ou de l'astigmatisme dynamique.

5. Procédé selon l'une des revendications 1 à 4, **caractérisé en ce que** le refroidissement et le chauffage servent à régler le profil de température asymétrique de l'élément optique (1) sur lequel sont disposés les éléments de Peltier (6) afin d'obtenir une dérivation par rapport aux autres éléments de la lentille, une compensation des champs désaxés ou une compensation des défauts de fabrication.

6. Sous-ensemble comprenant des éléments optiques, notamment des lentilles, muni d'un dispositif d'équilibrage de la température, plusieurs éléments de Peltier (6) étant disposés sur au moins un élément optique (1) en étant répartis sur son pourtour, des éléments de liaison (10) conducteurs de chaleur étant disposés entre les éléments de Peltier (6) et l'élément optique (1), comprenant une possibilité d'inversion de la polarité de chacun ou de plusieurs des éléments de Peltier (6), **caractérisé en ce que** les éléments de Peltier (6) sont couplés à l'élément optique (1) réalisé sous forme de lentille (1) séparément de la monture (2) de l'élément optique (1) directement par le biais d'éléments de liaison (10) séparés conducteurs de chaleur.

7. Sous-ensemble selon la revendication 6, **caractérisé en ce que** les éléments de Peltier (6) sont munis d'éléments de couplage thermique (9) dirigés vers l'extérieur.

8. Sous-ensemble selon la revendication 6 ou 7, **caractérisé en ce que** les éléments de Peltier (6) sont couplés directement à l'élément optique (1) par le biais des éléments de liaison (10) conducteurs de chaleur qui sont à chaque fois disposés entre un élément de Peltier (6) et l'élément optique (1).

9. Sous-ensemble selon la revendication 8, **caractérisé en ce que** les éléments de liaison (10) conducteurs de chaleur sont munis de tenons dirigés vers l'élément optique (1).

10. Sous-ensemble selon l'une des revendications 6 à 9, **caractérisé en ce qu'**il est un objectif (3), notamment un objectif de projection microlithographique.

11. Équipement de projection microlithographique comprenant un sous-ensemble selon l'une des revendications 6 à 10.
